# NEUE EUROPÄISCHE PATENTSCHRIFT

(11) **EP 0 752 589 B2**
(45) Veröffentlichungstag und Bekanntmachung des Hinweises auf die Entscheidung über den Einspruch: **04.07.2007**
(45) Hinweis auf die Patenterteilung: 28.04.1999
(21) Anmeldenummer: 96110342.1
(22) Anmeldetag: 27.06.1996
(51) Int. Cl.: G01R 11/04

(54) **Elektrizitätszähler**
Electricity meter
Compteur électrique

(30) Priorität: 07.07.1995 DE 19524819; 12.07.1995 DE 19525408
(43) Veröffentlichungstag der Anmeldung: 08.01.1997
(73) Patentinhaber: Industrie-Technik Fröschl GmbH, 93194 Walderbach (DE)
(72) Erfinder: Lottner, Günter Penting, 92431 Neunburg v. Wald (DE)
(74) Vertreter: Graf, Helmut

(56) Entgegenhaltungen:
- EP-A- 0 421 320
- WO-A-86/04994
- DE-A1- 2 746 432

## Beschreibung

Die Erfindung bezieht sich auf einen Elektrozähler zur Messung des Verbrauchs gemäß Oberbegriff Patentanspruch 1 und dabei speziell auf einen elektronischen Zähler oder Hybrid-Zähler (siehe z.B. WO 86/04994).

Derartige Zähler sind in der Regel zwanzig Jahre oder länger im Einsatz. Dementsprechend sind die Komponenten, insbesondere auch der heute noch im Einsatz befindlichen mechanischen Zähler bezüglich Verschleißsicherheit und Festigkeit für diese lange Betriebszeit ausgelegt. Bei elektronischen Zählern bestehen zwar Probleme hinsichtlich eines mechanischen Verschleißes nicht, allerdings verwenden diese Zähler auch Bauteile, deren einwandfreie Funktion durch Alterung zeitlich begrenzt ist. Dies gilt insbesondere für die bei elektronischen Zählern verwendete LCD-Anzeige, deren Lebensdauer in der Regel wesentlich kleiner ist als die für einen solchen Zähler vorgesehene Einsatzdauer.

Es ist daher eine mehrmalige Reparatur eines solchen elektronischen Zählers zu erwarten, und zwar jeweils mit einer Demontage des reparaturbedürftigen Zählers und einer Neumontage eines funktionsfähigen Austauschzählers. Reparaturen eines Zählers an Ort und Stelle sind nicht möglich, da jedes Öffnen oder Reparieren eines Zählers anschließend eine Beglaubigungsprüfung des reparierten Zählers durch ein Eichamt oder eine staatlich anerkannte Prüfstelle erfordert.

Zum Austausch einer schadhaften LCD-Anzeige muß also der betreffende Zähler an eine geeignete Reparaturwerkstatt transportiert werden, was evtl. mit größeren Transportwegen verbunden ist. Nach dem Austausch der schadhaften LCD-Anzeige muß im Eichamt oder in der staatlich anerkannten Prüfstelle die Beglaubigungsprüfung durchgeführt und der Zähler für den weiteren Einsatz wieder freigegeben werden. Erst mit dieser Beglaubigungsprüfung und Freigabe ist eine Weiterverwendung des Zählers als Meßgerät zur Erfassung des elektrischen Verbrauchs im gewerblichen Bereich möglich. Bei allen vorgenannten Schritten fallen Kosten durch Arbeitseinsatz und/oder Transport an, welche in ihrer Gesamtheit die Rentabilität der Reparatur in Frage stellen.

Bekannt ist ein Elektrizitätszähler mit einem vorzugsweise nach dem Induktionsprinzip arbeiteten Drehstrom-Meßwerk (DE 39 33 356 oder Familienmitglied EP-A-0 421 320), bei dem das Meßwerk zusammen mit der Anzeigeeinrichtung in einem Raum des Gehäuses für die eichpflichtigen Komponenten untergebracht ist. Das Gehäuse des Zählers besitzt einen weiteren getrennten Raum, in welchem Zusatzgeräte eingebaut werden können, die zusätzlich zu der eigentlichen Meßfunktion zusätzliche Funktionen ermöglichen, beispielsweise Rundsteuerempfänger usw.

Die Anwendung des Konstruktionsprinzips dieses bekannten Elektrizitätszählers auf nichtmechanische, nämlich elektronische Zähler hätte exakt die vorstehend genannten Nachteile.

Aufgabe der Erfindung ist es, einen Elektrizitätszähler aufzuzeigen, der auch bei Ausbildung als elektronischer Zähler eine lange Einsatzdauer ermöglicht.

Zur Lösung dieser Aufgabe ist ein Elektrozähler entsprechend dem kennzeichnenden Teil des Patentanspruches 1 ausgebildet.

Die Besonderheit des erfindungsgemäßen Elektrozählers besteht darin, daß das eigentliche Herzstück des Zählers, nämlich das Meßwerk so aufgeteilt ist, daß dessen eichpflichtige Komponenten einschließlich eines Speichers zum Speichern der Daten zugangsgeschützt in einem ersten Raum für die eichpflichtige Komponenten und das Anzeigedisplay in einem zweiten Raum untergebracht sind, der von hierfür befugten Personen geöffnet werden kann. Im ersten Raum für die eichpflichtige Komponenten befinden sich sämtliche der Beglaubigungsprüfung und Eichpflicht unterliegenden Kompontenten des Meßwerkes.

Durch diese Ausbildung ist im Bedarfsfall ein Austauschen des Anzeigedisplays, beispielsweise der LCD-Anzeige möglich und zwar ohne Zähleraustausch und Beglaubigungsprüfung.

Weist der Elektrizitätszähler andere, nicht eichpflichtige Zusatzeinrichtungen oder Elemente auf wie z.B. Rundsteuerempfänger, Modem, Schaltuhr, so sind auch diese in dem zweiten Raum oder aber in einem zusätzlichen weiteren Raum untergebracht.

Jeder zweite Raum ist durch wenigstens einen Deckel verschlossen, der zwar von autorisierten Personen geöffnet werden kann, gegen ein Öffnen durch Unbefugte aber gesichert bzw. geschützt ist, und zwar entweder dadurch, daß das Öffnen des Deckels nur durch eine bewußte und sichtbare Beschädigung dieses Deckels oder einer Sicherungsplombierung möglich ist.

Der Deckel ist dabei zumindest in einem Teilbereich transparent, so daß durch diesen Deckel insbesondere auch die Anzeige lesbar ist.

Der besondere Vorteil der Erfindung besteht darin, daß von autorisierten Personen nicht eichpflichtige Komponenten des Zählers ausgetauscht werden können. Ein aufwendiges Austauschen eines reparaturbedürftigen Zählers sowie eine mit hohen Kosten verbundene Reparatur in einer Werkstatt sowie eine erneute Eichung bzw. Beglaubigungsprüfung des Zählers sind somit nicht notwendig.

Weiterbildungen der Erfindung sind Gegenstand der Unteransprüche.

Die Erfindung wird im folgenden anhand der Figuren an einem Ausführungsbeispiel näher erläutert. Es zeigen:

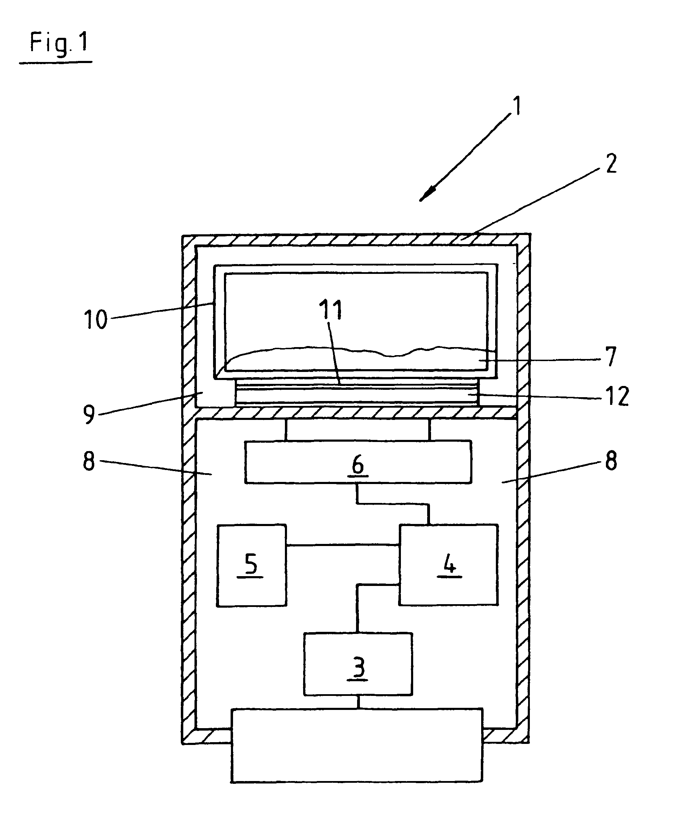

- Fig. 1: in vereinfachter schematischer Darstellung ein Blockdiagramm eines elektronischen Zählers gemäß der Erfindung zur Messung des Verbrauchs an elektrischer Energie, mit einem unter einem Displaydeckel vorgesehenen austauschbaren Anzeigedisplay;
- Fig. 2: in vereinfachter Darstellung und in Draufsicht den Displaydeckel;
- Fig. 3: in vereinfachter Darstellung einen Schnitt entsprechend der Linie I-I der Fig. 2.

In den Figuren ist 1 ein elektronischer Zähler, der zur Messung und Erfassung der von einem Stromkunden verbrauchten elektrischen Energie verwendet wird.

Der Zähler 1 besitzt in einem geschlossenen Gehäuse 2 eine Meßeinrichtung 3 zur Strom- und Spannungserfassung sowie eine Meß- und Auswertelektronik 4, der u.a. auch ein Speicher 5 zum Speichern der ermittelten Verbrauchswerte sowie anderer Daten zugeordnet ist und die über einen Controller 6 eine LCD-Anzeige 7 ansteuert, und zwar zum Anzeigen des Zählerstandes sowie anderer Daten und Informationen, ggf. auch auf Anforderung.

Die Meßeinrichtung 7, die Meß- und Auswertelektronik 4, der Speicher 5 sowie der Controller 6 befinden sich in einem zugangsgeschützten Raum 8 (erster Raum) des Gehäuses 2. Die LCD-Anzeige 7 ist in einem Teilraum 9 (zweiter Raum) des Gehäuses 2 vorgesehen, der durch Wandungen von dem zugangsgeschützten Raum 8 getrennt und nach außen durch einen Display-Deckel 10 verschlossen ist.

Die LCD-Anzeige 7 ist auswechselbar und besitzt hierzu eine Mehrfach-Steckerleiste 11, die an eine in dem Teilraum 9 zugängliche Mehrfach-Buchsenleiste 12 angeschlossen ist, und zwar für eine Verbindung der LCD-Anzeige 7 mit Ausgängen des Controllers 6.

Der Teilraum 9 befindet sich an der Vorderseite des Zählers 1 und der Display-Deckel 10 ist zumindest in einem Teilbereich aus einem transparenten bzw. durchscheinenden Material hergestellt, so daß die im Teilraum 9 untergebrachte LCD-Anzeige durch den Displaydeckel 10 hindurch an der Vorderseite des Zählers 1 sichtbar ist.

Bei der dargestellten Ausführungsform ist der Display-Deckel 10 einstückig aus transparentem Kunststoff gefertigt. Unabhängig hiervon ist dieser Displaydeckel so ausgebildet, daß es keinem Unbefugten möglich ist, den Deckel zu entfernen bzw. auf die LCD-Anzeige 7 einzuwirken, ohne daß dabei sichtbare Schäden am Deckel und/oder am Zähler 1 hervorgerufen werden. Der Displaydeckel 10 ist hierbei beispielsweise so ausgebildet, daß er nur durch Zerstören oder durch Lösen einer Plombe geöffnet werden kann.

Weiterhin ist durch entsprechende Ausbildung des Controllers 6 dafür gesorgt, daß auch über die Kontakte der Mehrfachbuchsenleiste 12 nach dem Öffnen des Displaydeckels 10 von außen her auf keinen Fall auf die Meß- und Auswertelektronik 4 und auf die mit dieser zusammenwirkenden Funktionselemente im Sinne einer Manipulierung des Zählers eingewirkt werden kann oder eine elektrische Zerstörung der im geschützten Raum 8 untergebrachten Elemente möglich ist. Der Controller 6 weist hierzu beispielsweise u.a. an seinen Ausgängen galvanische Trennungen in Form von Opto-Kopplern auf.

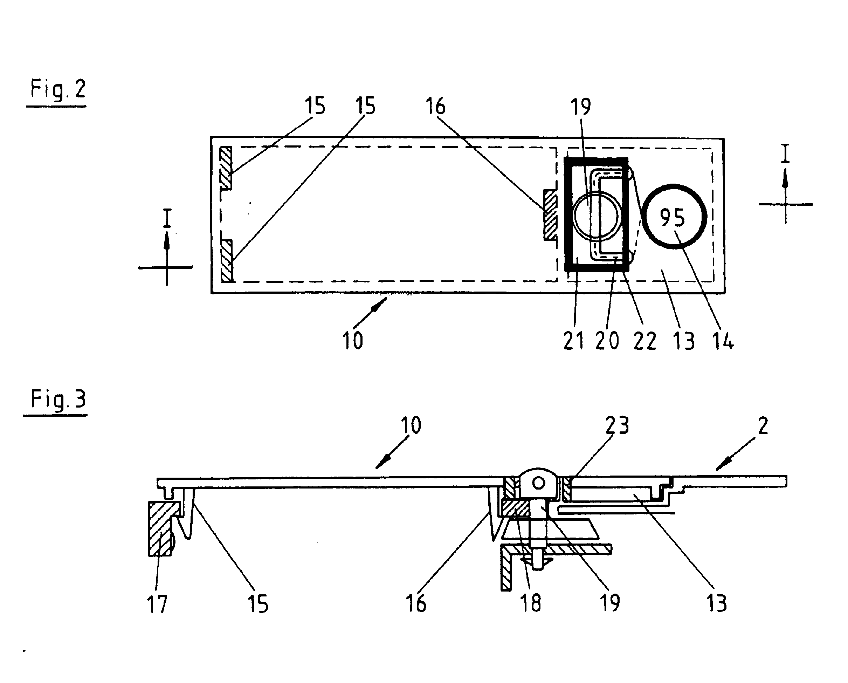

Die Fig. 2 und 3 zeigen eine mögliche Ausbildung des Display-Deckels 10. Bei dieser Ausführungsform ist der Displaydeckel 10 im wesentlichen rechteckförmig ausgebildet und deckt zusätzlich zu dem Teilraum 9, in welchem die LCD-Anzeige 7 untergebracht ist auch noch einen weiteren Teilraum 13 ab, der zur Aufnahme einer durch den Displaydeckel 10 ebenfalls abgedeckten Sicherungsplombe 14 dient. Der Displaydeckel 10 ist an seiner Innenseite mit angeformten Rastnasen 15 und 16 versehen, die über die Innenseite wegstehen und von denen die beiden an einer Schmalseite des rechteckförmigen Deckels 10 vorgesehenen Rastnasen 15 beim Aufsetzen des Deckels auf das Gehäuse 2 an Rasterungen 17 einrasten, die am Gehäuse 2 am Öffnungsrand des Raumes 9 gebildet sind. Die Rastnase 16 ist von den Rastnasen 15 entfernt dort vorgesehen, wo der den Teilraum 9 abdeckende Teil des Display-Deckels 10 endet. Die Rastnase 16 wirkt mit einer Rasterung 18 zusammen, die am Gehäuse 2 durch eine Plomben-Schraube 19 gehalten ist. Die Schraube 19, die mit ihrem Gewinde in ein Muttergewinde des Gehäuses 2 eingreift, besitzt an ihrem Kopf eine Öffnung, durch die der Draht 20 der Sicherungsplombe 19 hindurchgeführt ist. Der Deckel 10 besitzt im Bereich der Schraube 19 eine rechteckförmige Öffnung 22, in der u.a. der Kopf der Schraube 19 aufgenommen ist. An der Innenseite des Display-Deckels 10 ist ein die Öffnung 21 umschließender Rand 22 vorgesehen, der zumindest an der der Rastnase 16 abgewandten Seite der Schraube 19 von einem Wandabschnitt und der Steg 23 des Gehäuses 2 gebildet ist. In diesem Steg sind Öffnungen vorgesehen, durch die der Draht 20 hindurchgeführt ist. Die Plombe 14 befindet sich dann an der der Schraube 19 abgewandten Seite des Steges 23 unterhalb des dortigen Teilbereichs des Deckels 10 und durch diesen Deckel sichtbar.

Bei vormontierter, mit der Plombe 14 gesicherter Schraube 19 und bei durch diese Schraube gehaltenem Rastelement 18 kann der Display-Deckel 10 durch Aufdrücken und federndes Einrasten in besonders einfacher Weise montiert werden. Zum Entfernen des Deckels 10 ist notwendig, den im Bereich der Öffnung 22 zugänglichen Draht 20 zu durchtrennen, so daß dann nach dem Lösen der Schraube 19 der Display-Deckel 10 abgenommen werden kann.

Der besondere Vorteil des Zählers 1 besteht darin, daß im Bedarfsfalle nach dem Abnehmen des Display-Deckels 10 die LCD-Anzeige 7 beispielsweise bei einem Defekt dieser Anzeige ausgetauscht werden kann, und zwar selbstverständlich durch eine hierzu autorisierte Person. Das Austauschen der LCD-Anzeige erfolgt ohne Beeinträchtigung der übrigen Funktion des Zählers 1 bei dem jeweiligen Benutzer. Für die Reparatur der LCD-Anzeige ist somit auch kein aufwendiges Austauschen des gesamten Zählers sowie eine Reparatur dieses Zählers beim Hersteller usw. notwendig. Insbesondere beeinträchtigt das Austauschen der LCD-Anzeige auch nicht die Gültigkeit der Beglaubigung bzw. der Eichung des Zählers 1, d.h. dieser Zähler muß insbesondere auch nach dem Austauschen der LCD-Anzeige nicht in aufwendiger Weise neu geprüft und geeicht werden.

Bei entsprechender Ausbildung können zusätzlich zu der LCD-Anzeige 7 unter dem Display-Deckel 10 in dem Teilraum 9 auch noch andere Funktionselemente des Zählers 1 für Unbefugte zugriffsgeschützt, aber für autorisierte Personen austauschbar und/oder zugänglich vorgesehen werden, beispielsweise das dem Zähler zugeordnete Leistungsschild mit Eigentumsvermerk bestehend aus Eigentümername, Eigentümernummer, Barcode usw., sowie auch weitere, nicht eichpflichtige Zusatzeinrichtungen des Zählers 1, wie z.B. Rundsteuerempfänger, Modem oder Schaltuhr usw., und zwar an Steckplätzen, die hierfür herstellerseitig bereits vorgesehen sind.

Die Erfindung wurde voranstehend an einem Ausführungsbeispiel beschrieben. Es versteht sich, daß zahlreiche Änderungen sowie Abwandlungen möglich sind, ohne daß dadurch der der Erfindung zugrundeliegende Erfindungsgedanke verlassen wird.

### Bezugszeichenliste

- 1: Zähler
- 2: Gehäuse
- 3: Meßeinrichtung
- 4: Auswert- und Meßelektronik
- 5: Speicher
- 6: Controller
- 7: LCD-Anzeige
- 8: Gehäuseinnenraum zur Aufnahme von eichpflichtigen Komponenten
- 9: Teilraum zur Aufnahme nicht eichpflichtiger Komponenten
- 10: Displaydeckel
- 11: Steckerleiste
- 12: Mehrfachbuchse
- 13: Teilraum
- 14: Sicherungsplombe
- 15, 16: Rastnase
- 17, 18: Gegenrast
- 19: Sicherungsschraube
- 20: Plombendraht
- 21: Öffnung
- 22: Rahmen
- 23: Steg

## Patentansprüche

1. Elektronischer Zähler zur Erfassung des Verbrauchs an elektrischer Energie, mit einem Gehäuse (2), mit einem eine Anzeige aufweisenden Meßwerk, dessen eichpflichtige Komponenten (3, 4, 5, 6) in einem zugangsgeschützten Raum (8) des Gehäuses (2) untergebracht sind, welches wenigstens einen von dem Raum für die eichpflichtige Komponenten getrennten weiteren Raum (9) aufweist, in dem zusätzliche, nicht eichpflichtige Komponenten (7) des Zählers austauschbar vorgesehen sind und der durch wenigstens einen gegen unbefugtes Öffnen gesicherten Deckel (10) verschlossen ist, **dadurch gekennzeichnet, daß** im Raum (8) für die eichpflichtige Komponenten ein Speicher (5) für die Daten und im weiteren Raum (9) die die Anzeige des Zählers bildende Anzeige (7) des Meßwerks untergebracht ist, und daß die Anzeige (7) über Ausgänge eines Controllers (6) ansteuerbar ist, der eine Einwirkung auf die eichpflichtigen Komponenten (3, 4, 5, 6) über seine Ausgänge verhindert.

2. Zähler nach Anspruch 1, **dadurch gekennzeichnet, daß** die Anzeige eine LCD-Anzeige (7) ist.

3. Zähler nach Anspruch 1 oder 2, **dadurch gekennzeichnet, daß** im weiteren Raum (9) Steckplätze für nachträglich einbaubare, nicht eichpflichtige Zählerzusatzeinrichtungen, wie Rundsteuerempfänger, Modem oder Schaltuhr vorgesehen sind.

4. Zähler nach einem der Ansprüche 1- 3, **dadurch gekennzeichnet, daß** der den weiteren Raum (9) verschließende Deckel (10) so ausgeführt oder so am Gehäuse (2) des Zählers (1) befestigt ist, daß er nur durch sichtbare Zerstörung geöffnet werden kann.

5. Zähler nach einem der Ansprüche 1 - 4, **dadurch gekennzeichnet, daß** der den weiteren Raum (9) verschließende Deckel (10) durch wenigstens eine Sicherungsplombe (14) gegen unbefugtes Öffnen gesichert ist.

6. Zähler nach einem der Ansprüche 1 - 5, **dadurch gekennzeichnet, daß** der den weiteren Raum (9) verschließende Deckel (10) zumindest in einem Teilbereich aus einem durchsichtigen Material, vorzugsweise aus transparentem Kunststoff besteht.

7. Zähler nach einem der Ansprüche 1 - 6, **dadurch gekennzeichnet, daß** der den weiteren Raum (9) verschließende Deckel (10) durch Einrasten am Gehäuse (2) gehalten ist.

8. Zähler nach einem der Ansprüche 1 - 7, **dadurch gekennzeichnet, daß** wenigstens zwei weitere Räume (9) zur Aufnahme von nicht eichpflichtigen Elementen des Zählers vorgesehen sind.

9. Zähler nach einem der Ansprüche 1 - 8, **dadurch gekennzeichnet, daß** der Controller (6) an seinen Ausgängen galvanische Trennungen in Form von Opto-Kopplern aufweist.

## Claims

1. Electronic meter for calculating the consumption of electric energy, with a housing (2), a measuring element with an indicator whose components (3,4,5,6) which require calibration are contained in an access-restricted chamber (8) in the housing (2) which has at least one further chamber (9) which is separate from the chamber for the components requiring calibration wherein additional components (7) of the meter which do not require calibration are provided interchangeable in this further chamber which is closed by at least one cover (10) which is secured against unauthorised opening, **characterised in that** a memory (5) for the data is housed in the chamber (8) for the components requiring calibration whilst the indicator (7) of the measuring element forming the indicator for the meter is housed in the further chamber (9), and that the indicator (7) can be driven through outputs of a controller (6) which prevents action via its outputs on the components (3, 4,5, 6) requiring calibration.

2. Meter according to claim 1 **characterised in that** the indicator is an LCD display (7).

3. Meter according to claim 1 or 2 **characterised in that** the further chamber (9) is provided with plugs for additional meter devices which do not require calibration and which can be installed subsequently as an accessory, such as a ripple control receiver, modem or time switch.

4. Meter according to one of claims 1 to 3 **characterised in that** the cover (10) which closes the further chamber (9) is designed or is fixed on the housing (2) of the meter (1) in such a way that it can only be opened through visible destruction.

5. Meter according to one of claims 1 to 4 **characterised in that** the cover (10) which closes the further chamber (9) is secured against unauthorised opening through at least one security seal.

6. Meter according to one of claims 1 to 5 **characterised in that** the cover (10) which closes the further chamber (9) consists at least in a partial area of a transparent material, preferably of transparent plastics.

7. Meter according to one of claims 1 to 6 **characterised in that** the cover (10) which closes the further chamber (9) is held on the housing (2) through detent engagement.

8. Meter according to one of claims 1 to 7 **characterised in that** at least two further chambers (9) are provided to hold elements of the meter which do not require calibration.

9. Meter according to one of claims 1 to 8 **characterised in that** the controller (6) has at its outputs galvanic isolators in the form of optocouplers.

## Revendications

1. Compteur électronique destiné à déterminer la consommation d'énergie électrique, comprenant un boîtier (2) avec un système de mesure présentant un affichage dont les composants soumis à un étalonnage obligatoire (3, 4, 5, 6) sont logés dans un espace à accès protégé (8) du boîtier (2), lequel présente au moins un espace supplémentaire (9) séparé de l'espace pour les composants soumis à un étalonnage obligatoire, dans lequel des composants supplémentaires (7) du compteur, non soumis à un étalonnage obligatoire, sont prévus de manière remplaçable, et qui est fermé par au moins un couvercle (10) assuré contre une ouverture non autorisée, **caractérisé en ce qu'**une mémoire (5) pour les données est logée dans l'espace (8) pour les composants soumis à un étalonnage obligatoire et l'affichage (7) du système de mesure formant l'affichage du compteur est logé dans l'espace supplémentaire (9), et **en ce que** l'affichage (7) peut être commandé par l'intermédiaire de sorties d'un contrôleur (6) qui empêche une action sur les composants soumis à un étalonnage obligatoire (3, 4, 5, 6) par l'intermédiaire de ses sorties.

2. Compteur selon la revendication 1, **caractérisé en ce que** l'affichage est un affichage à cristaux liquides (LCD) (7).

3. Compteur selon la revendication 1 ou 2, **caractérisé en ce que** des emplacements de connexion sont prévus dans l'espace supplémentaire (9) pour des dispositifs supplémentaires du compteur non soumis à un étalonnage obligatoire pouvant être montés ultérieurement, tels qu'un récepteur de télécommande centralisée, un modem ou un interrupteur horaire.

4. Compteur selon l'une quelconque des revendications 1-3, **caractérisé en ce que** le couvercle (10) fermant l'espace supplémentaire (9) est réalisé de telle manière ou est fixé au boîtier (2) du compteur (1) de telle manière qu'il ne puisse être ouvert que par une destruction visible.

5. Compteur selon l'une quelconque des revendications 1-4, **caractérisé en ce que** le couvercle (10) fermant l'espace supplémentaire (9) est assuré contre une ouverture non autorisée par au moins un plomb de sûreté (14).

6. Compteur selon l'une quelconque des revendications 1-5, **caractérisé en ce que** le couvercle (10) fermant l'espace supplémentaire (9) est constitué au moins en partie d'une matière transparente, de préférence de matière synthétique transparente.

7. Compteur selon l'une quelconque des revendications 1-6, **caractérisé en ce que** le couvercle (10) fermant l'espace supplémentaire (9) est maintenu sur le boîtier (2) par encliquetage.

8. Compteur selon l'une quelconque des revendications 1-7, **caractérisé en ce qu'**au moins deux espaces supplémentaires (9) sont prévus pour accueillir des éléments du compteur non soumis à un étalonnage obligatoire.

9. Compteur selon l'une quelconque des revendications 1 - 8,**caractérisé en ce que** le contrôleur (6) présente à ses sorties des séparations galvaniques sous la forme de coupleurs optiques.
